# EUROPÄISCHE PATENTSCHRIFT

(11) **EP 3 753 048 B1**
(45) Veröffentlichungstag und Bekanntmachung des Hinweises auf die Patenterteilung: **22.11.2023**
(21) Anmeldenummer: 18716971.9
(22) Anmeldetag: 03.04.2018
(51) Int. Cl.: H01L 23/00, H03K 17/0814, H03K 17/10, H01L 25/075, H01L 25/16

(54) **SCHALTUNGSANORDNUNG, STROMRICHTERMODUL UND VERFAHREN ZUM BETREIBEN DES STROMRICHTERMODULS**
CIRCUIT ARRANGEMENT, POWER CONVERTER MODULE, AND METHOD FOR OPERATING THE POWER CONVERTER MODULE
CIRCUIT, MODULE CONVERTISSEUR ET PROCÉDÉ DE FONCTIONNEMENT DU MODULE CONVERTISSEUR

(43) Veröffentlichungstag der Anmeldung: 23.12.2020
(73) Patentinhaber: Siemens Energy Global GmbH & Co. KG, 81739 München (DE)
(72) Erfinder: DÖRING, David, 91074 Herzogenaurach (DE); GIERING, Gerald Franz, 90562 Kalchreuth (DE); WÜRFLINGER, Klaus, 90419 Nürnberg (DE)
(86) Internationale Anmeldenummer: PCT/EP2018/058454
(87) Internationale Veröffentlichungsnummer: WO 2019/192674

(56) Entgegenhaltungen:
- EP-A1- 3 107 109
- CN-A- 101 246 877
- KR-A- 20060 028 487
- US-A1- 2009 127 685

## Beschreibung

Die Erfindung betrifft eine Schaltungsanordnung, die mehrere in Reihe geschaltete Schalterbaugruppen mit jeweils einem Halbleiterschalter aufweist, ein Stromrichtermodul mit einer derartigen Schaltungsanordnung und ein Verfahren zum Betreiben des Stromrichtermoduls.

Beim Betrieb eines Halbleiterschalters wie eines Bipolartransistors mit isoliertem Gate (IGBT = Insulated-Gate Bipolar Transistor) darf eine Spannung zwischen den Lastanschlüssen des Halbleiterschalters (im Falle eines IGBT zwischen dem Kollektor und dem Emitter) eine Maximalspannung nicht überschreiten, um den Halbleiterschalter nicht zu beschädigen oder zu zerstören. Insbesondere ist dies bei einer Reihenschaltung von Halbleiterschaltern erforderlich, bei der eine an der Reihenschaltung anliegende Spannung auf die einzelnen Halbleiterschalter aufgeteilt wird. Bei einer Reihenschaltung von Halbleiterschaltern kann insbesondere der Fall eintreten, dass ein Halbleiterschalter aufgrund eines Defekts ausfällt und keine Spannung mehr aufnehmen kann, wodurch die anderen Halbleiterschalter einer höheren Spannung ausgesetzt werden. Um Überspannungen an in Reihe geschalteten IGBT im Fall des Ausfalls eines IGBT zu verhindern, sind beispielsweise Gate-Beschaltungen der IGBT (so genanntes Active Clamping) oder passive Beschaltungen des IGBT bekannt. Reihenschaltungen von Halbleiterschaltern werden insbesondere in Stromrichtermodulen verwendet.

EP 3 107 109 A1 offenbart einen Gleichstromleistungsschalter zum Schalten eines entlang einer schalterbezogenen Hauptstromflussrichtung fließenden Gleichstroms. Der Gleichstromleistungsschalter weist eine Reihenschaltung mit einer Mehrzahl an elektrisch in Reihe geschalteten Halbleiterschaltelementen auf. Elektrisch parallel zu dieser Schalterreihenschaltung ist ein Freilaufpfad geschaltet, der unabhängig vom Schaltzustand der Halbleiterschaltelemente einen Stromfluss entgegen der Hauptstromflussrichtung ermöglicht oder zumindest ermöglichen kann.

Der Erfindung liegt die Aufgabe zugrunde, eine Schaltungsanordnung mit in Reihe geschalteten Halbleiterschaltern, insbesondere für ein Stromrichtermodul, anzugeben, die insbesondere hinsichtlich des Schutzes der Halbleiterschalter vor Überspannungen bei einem Ausfall eines Halbleiterschalters oder mehrerer Halbleiterschalter verbessert ist.

Die Aufgabe wird erfindungsgemäß durch eine Schaltungsanordnung mit den Merkmalen des Anspruchs 1, ein Stromrichtermodul mit den Merkmalen des Anspruchs 7 und ein Verfahren mit den Merkmalen des Anspruchs 11 gelöst.

Vorteilhafte Ausgestaltungen der Erfindung sind Gegenstand der Unteransprüche.

Eine erfindungsgemäße Schaltungsanordnung umfasst mehrere in Reihe geschaltete Schalterbaugruppen, die jeweils eine Parallelschaltung von drei Baugruppenkomponenten aufweisen, wobei eine erste Baugruppenkomponente ein Halbleiterschalter ist, eine zweite Baugruppenkomponente eine Freilaufdiode ist und die dritte Baugruppenkomponente ein Überspannungsableiter ist. Die Baugruppenkomponenten sind (räumlich übereinander oder nebeneinander) als ein Baugruppenkomponentenstapel angeordnet, wobei die drei Baugruppenkomponenten jeder Schalterbaugruppe in dem Baugruppenkomponentenstapel aufeinander folgend angeordnet sind. Je zwei einander benachbarte Baugruppenkomponenten sind durch eine Direktverbindung elektrisch direkt miteinander verbunden. Jede Direktverbindung, die zwei Baugruppenkomponenten zweier verschiedener Schalterbaugruppen verbindet, ist elektrisch mit jeder der beiden ihr zweitnächsten Direktverbindungen durch eine Brückenverbindung verbunden. Jedes Stapelende des Baugruppenkomponentenstapels weist einen elektrischen Stapelanschluss auf, der durch eine Endbrückenverbindung mit der dem Stapelende zweitnächsten Direktverbindung zweier Baugruppenkomponenten elektrisch verbunden ist.

Zwei Baugruppenkomponenten werden als einander benachbart bezeichnet, wenn zwischen den beiden Baugruppenkomponenten in dem Baugruppenkomponentenstapel keine weitere Baugruppenkomponente angeordnet ist. Eine Direktverbindung wird als eine einer anderen Direktverbindung zweitnächste Direktverbindung bezeichnet, wenn der Baugruppenkomponentenstapel zwischen den beiden Direktverbindungen genau eine weitere Direktverbindung zweier Baugruppenkomponenten aufweist. Entsprechend wird eine Direktverbindung als die einem Stapelende zweitnächste Direktverbindung bezeichnet, wenn der Baugruppenkomponentenstapel zwischen dem Stapelende und dieser Direktverbindung genau eine weitere Direktverbindung zweier Baugruppenkomponenten aufweist.

Durch den Überspannungsableiter einer Schalterbaugruppe wird eine an dem Halbleiterschalter anliegende Spannung, das heißt eine Spannung zwischen den Lastanschlüssen des Halbleiterschalters, auf einen Maximalwert begrenzt, um eine Überspannung an dem Halbleiterschalter zu verhindern. Dadurch wird insbesondere verhindert, dass ein Defekt des Halbleiterschalters einer Schalterbaugruppe eine Überspannung an dem Halbleiterschalter einer anderen Schalterbaugruppe verursacht. Die Erfindung sieht ferner eine gestapelte Anordnung der Baugruppenkomponenten vor, wobei die Baugruppenkomponenten jeder Schalterbaugruppe aufeinander folgend angeordnet sind. Dies ermöglicht vorteilhaft eine sehr einfache und kostengünstige Realisierung der Verschaltung der gestapelten Baugruppenkomponenten durch Direktverbindungen, die jeweils zwei einander benachbarte Baugruppenkomponenten verbinden, sowie durch Brückenverbindungen und Endbrückenverbindungen, die die Direktverbindungen miteinander und den Stapelanschlüssen verbinden. Insgesamt ermöglicht die Erfindung eine Reihenschaltung von Halbleiterschaltern, in der die Halbleiterschalter vor Überspannungen geschützt sind und zweckmäßig und platzsparend gestapelt angeordnet sind.

Eine Ausgestaltung der Erfindung sieht vor, dass der Halbleiterschalter und die Freilaufdiode jeder Schalterbaugruppe einander benachbart angeordnet sind. Diese Anordnung des Halbleiterschalters und der Freilaufdiode jeder Schalterbaugruppe bewirkt vorteilhaft eine niederinduktive Anordnung des Halbleiterschalters und der Freilaufdiode jeder Schalterbaugruppe.

Bei einer weiteren Ausgestaltung der Erfindung sind die Halbleiterschalter Bipolartransistoren mit isoliertem Gate. Insbesondere verbindet jede Direktverbindung, die zwei Bipolartransistoren mit isoliertem Gate verbindet, den Emitter eines Bipolartransistors mit isoliertem Gate und den Kollektor des anderen Bipolartransistors mit isoliertem Gate. Ferner verbindet jede Direktverbindung, die einen Bipolartransistor mit isoliertem Gate und eine Freilaufdiode verbindet, vorzugsweise entweder den Emitter des Bipolartransistors mit isoliertem Gate und die Anode der Freilaufdiode oder den Kollektor des Bipolartransistors mit isoliertem Gate und die Kathode der Freilaufdiode. Bipolartransistoren mit isoliertem Gate vereinigen Vorteile von Bipolartransistoren und Feldeffekttransistoren und sind daher besonders geeignete Halbleiterschalter, insbesondere für Schaltungsanordnungen für Stromrichtermodule.

Bei einer weiteren Ausgestaltung der Erfindung ist jede Brückenverbindung und/oder jede Endbrückenverbindung einstückig mit jeder mit ihr verbundenen Direktverbindung ausgeführt. Diese Ausgestaltung der Erfindung reduziert die Bauteilanzahl der Schaltungsanordnung.

Ein erfindungsgemäßes Stromrichtermodul umfasst eine Reihenschaltung mehrerer Schalterbaugruppen, die jeweils eine Parallelschaltung von drei Baugruppenkomponenten aufweisen, wobei eine erste Baugruppenkomponente ein Halbleiterschalter ist, eine zweite Baugruppenkomponente eine Freilaufdiode ist und die dritte Baugruppenkomponente ein Überspannungsableiter ist, eine mit den beiden Enden der Reihenschaltung verbundene Kondensatorschaltung mit wenigstens einem Kondensator und zwei Modulanschlüssen, die Endanschlüsse einer von einer ersten Baugruppenteilmenge der Schalterbaugruppen gebildeten Teilreihenschaltung sind. Dabei bilden die Baugruppenkomponenten aller Schalterbaugruppen oder wenigstens einer Teilmenge der Schalterbaugruppen eine erfindungsgemäße Schaltungsanordnung.

Die Vorteile eines erfindungsgemäßen Stromrichtermoduls ergeben sich aus den oben genannten Vorteilen einer erfindungsgemäßen Schaltungsanordnung.

Eine Ausgestaltung des Stromrichtermoduls sieht eine gerade Anzahl von Schalterbaugruppen vor, wobei die Mächtigkeit der ersten Baugruppenteilmenge der Schalterbaugruppen halb so groß wie die Anzahl der Schalterbaugruppen ist. Unter der Mächtigkeit einer endlichen Menge wird die Anzahl der Elemente der Menge verstanden. Mit anderen Worten weist die erste Baugruppenteilmenge des Stromrichtermoduls gemäß dieser Ausgestaltung ebenso viele Schalterbaugruppen wie eine zu der ersten Baugruppenteilmenge komplementäre zweite Baugruppenteilmenge auf. Dadurch können beide Baugruppenteilmengen gleichartig ausgeführt und eine Steuerung der Halbleiterschalter verbessert und vereinfacht werden.

Eine weitere Ausgestaltung des Stromrichtermoduls sieht ein Gehäuse vor, in dem die Schalterbaugruppen, die Kondensatorschaltung und ein Kühlmedium angeordnet sind. Das Kühlmedium ist beispielsweise ein Ester. Diese Ausgestaltung des Stromrichtermoduls ermöglicht eine Kühlung des Stromrichtermoduls durch ein Kühlmedium. Ein Ester ist ein besonders geeignetes Kühlmedium, da es hohe Brenn- und Flammpunkte, eine hohe Zündtemperatur, gute elektrische Isoliereigenschaften und eine hohe thermische Speicherfähigkeit aufweist und zudem ungiftig, leicht biologisch abbaubar und nicht wassergefährdend ist.

Das erfindungsgemäße Verfahren betrifft das Betreiben eines erfindungsgemäßen Stromrichtermoduls, dessen erste Baugruppenteilmenge wenigstens zwei Schalterbaugruppen aufweist und das eine zu der ersten Baugruppenteilmenge komplementäre zweite Baugruppenteilmenge mit wenigstens zwei Schalterbaugruppen aufweist. Bei dem Verfahren wird zu einer Energieaufnahme durch das Stromrichtermodul wenigstens ein Halbleiterschalter wenigstens einer Baugruppenteilmenge von Schalterbaugruppen abgeschaltet und wenigstens ein Halbleiterschalter derselben Baugruppenteilmenge von Schalterbaugruppen eingeschaltet.

Das erfindungsgemäße Verfahren nutzt aus, dass die Ableiter eines erfindungsgemäßen Stromrichtermoduls zur Aufnahme von Energie genutzt werden können, indem wenigstens ein Halbleiterschalter wenigstens einer Schalterbaugruppe abgeschaltet wird, während wenigstens ein Halbleiterschalter derselben Schalterbaugruppe eingeschaltet wird. Dabei werden Überspannungsableiter von einem elektrischen Strom durchflossen und erwärmt. Im Fall, dass die Schalterbaugruppen in einem Kühlmedium angeordnet sind, wird die Wärme teilweise durch das Kühlmedium abgeführt. Das erfindungsgemäße Verfahren sieht also neben einem Normalbetrieb des Stromrichtermoduls einen zusätzlichen Betriebsmodus des Stromrichtermoduls vor, in dem das Stromrichtermodul zur Aufnahme von Energie verwendet wird. Dieser Betriebsmodus unterscheidet sich von dem Normalbetrieb des Stromrichtermoduls dadurch, dass die Halbleiterschalter wenigstens einer Baugruppenteilmenge in voneinander verschiedenen Schaltzuständen betrieben werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 einen ersten Schaltplan einer Schaltungsanordnung mit zwei Schalterbaugruppen,
FIG 2 einen zweiten Schaltplan der in Figur 1 gezeigten Schaltungsanordnung, der der räumlichen Anordnung der Baugruppenkomponenten der Schaltungsanordnung entspricht,
FIG 3 schematisch die räumliche Anordnung der Baugruppenkomponenten der in Figur 1 gezeigten Schaltungsanordnung,
FIG 4 schematisch eine Schaltungsanordnung mit drei Schalterbaugruppen in einer Figur 3 entsprechenden Darstellung,
FIG 5 schematisch eine Schaltungsanordnung mit vier Schalterbaugruppen in einer Figur 3 entsprechenden Darstellung,
FIG 6 einen Schaltplan eines Stromrichtermoduls.

Einander entsprechende Teile sind in den Figuren mit denselben Bezugszeichen versehen.

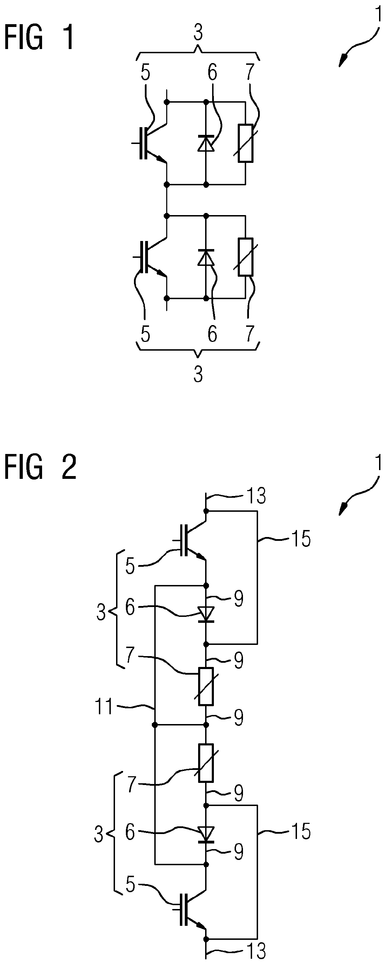

Die Figuren 1 bis 3 zeigen eine erfindungsgemäße Schaltungsanordnung 1 mit zwei in Reihe geschalteten Schalterbaugruppen 3. Jede Schalterbaugruppe 3 weist eine Parallelschaltung von drei Baugruppenkomponenten 5 bis 7 auf, wobei eine erste Baugruppenkomponente ein als ein IGBT ausgebildeter Halbleiterschalter 5 ist, eine zweite Baugruppenkomponente eine Freilaufdiode 6 ist und die dritte Baugruppenkomponente ein Überspannungsableiter 7 ist.

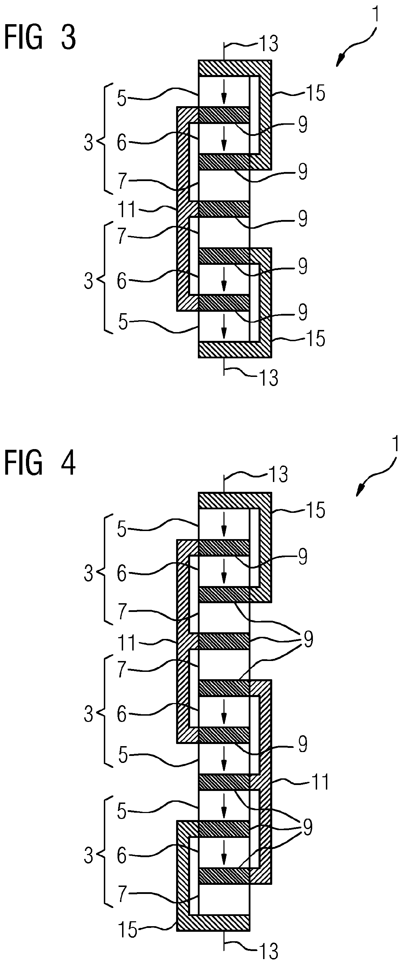

Die Figuren 1 und 2 zeigen äquivalente Schaltpläne der Schaltungsanordnung 1. Figur 3 verdeutlicht die räumliche Anordnung der Baugruppenkomponenten 5 bis 7 der Schaltungsanordnung 1. Der in Figur 1 gezeigte Schaltplan verdeutlicht die elektrische Verschaltung der Baugruppenkomponenten 5 bis 7. Der in Figur 2 gezeigte Schaltplan entspricht der in Figur 3 gezeigten räumlichen Anordnung der Baugruppenkomponenten 5 bis 7.

Die Baugruppenkomponenten 5 bis 7 sind räumlich übereinander als ein Baugruppenkomponentenstapel angeordnet. Je zwei einander benachbarte Baugruppenkomponenten 5 bis 7 sind durch eine Direktverbindung 9 elektrisch direkt miteinander verbunden.

Die Freilaufdiode 6 jeder Schalterbaugruppe 3 ist zwischen dem Halbleiterschalter 5 und dem Überspannungsableiter 7 der Schalterbaugruppe 3 angeordnet und somit durch jeweils eine Direktverbindung 9 mit dem Halbleiterschalter 5 und mit dem Überspannungsableiter 7 der Schalterbaugruppe 3 verbunden. Dabei ist die Anode der Freilaufdiode 6 der oberen Schalterbaugruppe 3 durch eine Direktverbindung 9 mit dem Emitter des Halbleiterschalters 5 der oberen Schalterbaugruppe 3 verbunden und die Kathode der Freilaufdiode 6 der unteren Schalterbaugruppe 3 ist durch eine Direktverbindung 9 mit dem Kollektor der unteren Schalterbaugruppe 3 verbunden. In Figur 3 sind die Orientierungen der Halbleiterschalter 5 hinsichtlich der Richtung von dem Kollektor zu dem Emitter und der Freilaufdioden 6 hinsichtlich der Richtung von der Anode zu der Kathode jeweils durch einen Pfeil dargestellt.

Die Überspannungsableiter 7 der beiden Schalterbaugruppen 3 sind einander benachbart angeordnet und somit durch eine Direktverbindung 9 verbunden. Die Reihenfolgen, in der die Baugruppenkomponenten 5 bis 7 der beiden Schalterbaugruppen 3 entlang des Baugruppenkomponentenstapels hintereinander angeordnet sind, sind daher relativ zueinander invertiert.

Die Direktverbindung 9, die die beiden Überspannungsableiter 7 verbindet, ist durch eine Brückenverbindung 11 elektrisch mit den beiden ihr zweitnächsten Direktverbindungen 9 zweier Baugruppenkomponenten 5 bis 7 verbunden, das heißt mit den beiden Direktverbindungen 9, die jeweils die Freilaufdiode 6 mit dem Halbleiterschalter 5 einer Schalterbaugruppe 3 verbinden.

Jedes Stapelende des Baugruppenkomponentenstapels weist einen elektrischen Stapelanschluss 13 auf, der durch eine Endbrückenverbindung 15 mit der dem Stapelende zweitnächsten Direktverbindung 9 zweier Baugruppenkomponenten 5 bis 7 elektrisch verbunden ist, das heißt einer Direktverbindung 9 zwischen einer Freilaufdiode 6 und einem Überspannungsableiter 7 einer Schalterbaugruppe 3.

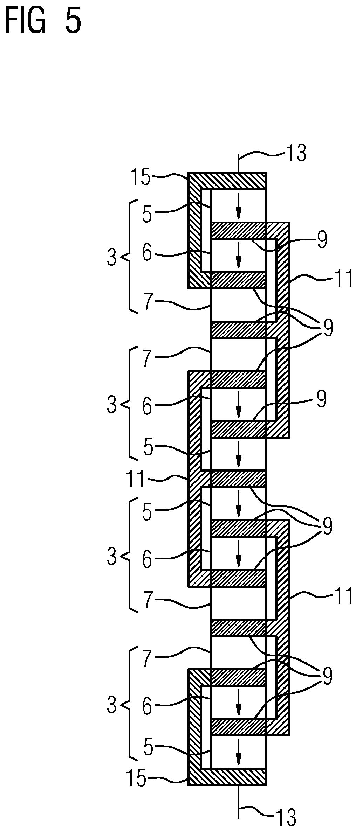

Die Figuren 4 und 5 zeigen weitere erfindungsgemäße Schaltungsanordnungen 1 in jeweils einer Figur 3 entsprechenden Darstellung, wobei Figur 4 eine Schaltungsanordnung 1 mit drei Schalterbaugruppen 3 zeigt und Figur 5 eine Schaltungsanordnung 1 mit vier Schalterbaugruppen 3 zeigt. Wie in den Figuren 1 bis 3 weist jede Schalterbaugruppe 3 eine Parallelschaltung von drei Baugruppenkomponenten 5 bis 7 auf, wobei eine erste Baugruppenkomponente ein als ein IGBT ausgebildeter Halbleiterschalter 5 ist, eine zweite Baugruppenkomponente eine Freilaufdiode 6 ist und die dritte Baugruppenkomponente ein Überspannungsableiter 7 ist.

Die Baugruppenkomponenten 5 bis 7 sind übereinander als ein Baugruppenkomponentenstapel angeordnet. Je zwei einander benachbarte Baugruppenkomponenten 5 bis 7 sind durch eine Direktverbindung 9 elektrisch direkt miteinander verbunden. Die Freilaufdiode 6 jeder Schalterbaugruppe 3 ist zwischen dem Halbleiterschalter 5 und dem Überspannungsableiter 7 der Schalterbaugruppe 3 angeordnet und somit durch jeweils eine Direktverbindung 9 mit dem Halbleiterschalter 5 und mit dem Überspannungsableiter 7 der Schalterbaugruppe 3 verbunden. Dabei ist entweder die Anode der Freilaufdiode 6 der Schalterbaugruppe 3 mit dem Emitter des Halbleiterschalters 5 oder die Kathode der Freilaufdiode 6 mit dem Kollektor der Schalterbaugruppe 3 verbunden. Wie in Figur 3 sind die Orientierungen der Halbleiterschalter 5 hinsichtlich der Richtung von dem Kollektor zu dem Emitter und der Freilaufdioden 6 hinsichtlich der Richtung von der Anode zu der Kathode jeweils durch einen Pfeil dargestellt.

Die beiden Halbleiterschalter 5 oder die beiden Überspannungsableiter 7 je zwei benachbarter Schalterbaugruppen 3 sind einander benachbart angeordnet und somit durch eine Direktverbindung 9 verbunden. Dabei verbindet jede Direktverbindung 9, die zwei Halbleiterschalter 5 verbindet, den Emitter eines Halbleiterschalters 5 und den Kollektor des anderen Halbleiterschalters 5.

Jede Direktverbindung 9, die zwei Baugruppenkomponenten 5 bis 7 zweier verschiedener Schalterbaugruppen 3 verbindet, ist durch eine Brückenverbindung 11 elektrisch mit den beiden ihr zweitnächsten Direktverbindungen 9 zweier Baugruppenkomponenten verbunden. Somit ist jede Direktverbindung 9, die die Überspannungsableiter 7 zweier Schalterbaugruppen 3 verbindet, durch eine Brückenverbindung 11 elektrisch mit den beiden Direktverbindungen 9 verbunden, die jeweils die Freilaufdiode 6 mit dem Halbleiterschalter 5 einer der beiden Schalterbaugruppen 3 verbinden, und jede Direktverbindung 9, die die Halbleiterschalter 5 zweier Schalterbaugruppen 3 verbindet, ist durch eine Brückenverbindung 11 elektrisch mit den beiden Direktverbindungen 9 verbunden, die jeweils die Freilaufdiode 6 mit dem Überspannungsableiter 7 einer der beiden Schalterbaugruppen 3 verbinden.

Wie bei der in den Figuren 1 bis 3 gezeigten Schaltungsanordnung 1 weist ferner jedes Stapelende des Baugruppenkomponentenstapels einen elektrischen Stapelanschluss 13 auf, der durch eine Endbrückenverbindung 15 mit der dem Stapelende zweitnächsten Direktverbindung 9 zweier Baugruppenkomponenten 5 bis 7 elektrisch verbunden ist.

Bei allen in den Figuren 1 bis 5 gezeigten Ausführungsbeispielen begrenzt der Überspannungsableiter 7 einer Schalterbaugruppe 3 die Spannung zwischen dem Kollektor und dem Emitter des Halbleiterschalters 5 der Schalterbaugruppe 3 auf einen für diesen Halbleiterschalter 5 vorgesehenen Maximalwert, um eine Überspannung zwischen dem Kollektor und dem Emitter zu verhindern. Wenn sich beispielsweise aufgrund eines Defekts eines Halbleiterschalters 5 einer ersten Schalterbaugruppe 3 eine an einer zweiten Schalterbaugruppe 3 anliegende Spannung erhöht, so begrenzt der Überspannungsableiter 7 der zweiten Schalterbaugruppe 3 die Spannung zwischen dem Kollektor und dem Emitter des Halbleiterschalters 5 der zweiten Schalterbaugruppe 3 auf den für diesen Halbleiterschalter 5 vorgesehenen Maximalwert und verhindert dadurch eine Schädigung oder Zerstörung dieses Halbleiterschalters 5.

Alle in den Figuren 1 bis 5 gezeigten Ausführungsbeispiele können dahin gehend abgewandelt werden, dass die Reihenfolge der Baugruppenkomponenten 5 bis 7 wenigstens einer Schalterbaugruppe 3 (insbesondere auch aller Schalterbaugruppen 3) in dem Baugruppenkomponentenstapel gegenüber der in der jeweiligen Figur 3 bis 5 gezeigten Reihenfolge geändert wird. Vorzugsweise sind jedoch der Halbleiterschalter 5 und die Freilaufdiode 6 jeder Schalterbaugruppe 3 einander benachbart angeordnet.

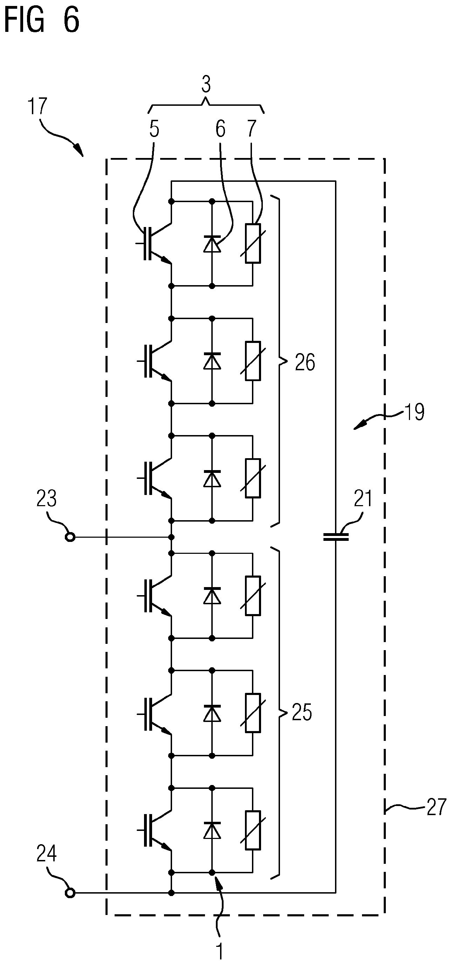

Figur 6 zeigt einen Schaltplan eines Stromrichtermoduls 17. Das Stromrichtermodul 17 weist eine Reihenschaltung von sechs Schalterbaugruppen 3 auf, die jeweils eine Parallelschaltung von drei Baugruppenkomponenten 5 bis 7 aufweisen, wobei eine erste Baugruppenkomponente ein als ein IGBT ausgebildeter Halbleiterschalter 5 ist, eine zweite Baugruppenkomponente eine Freilaufdiode 6 ist und die dritte Baugruppenkomponente ein Überspannungsableiter 7 ist.

Das Stromrichtermodul 17 weist ferner eine mit den beiden Enden der Reihenschaltung der Schalterbaugruppen 3 verbundene Kondensatorschaltung 19 auf, die in dem in Figur 6 gezeigten Ausführungsbeispiel einen Kondensator 21 aufweist, in anderen Ausführungsbeispielen aber alternativ eine Reihenschaltung mehrerer Kondensatoren 21 aufweisen kann.

Ferner weist das Stromrichtermodul 17 zwei Modulanschlüsse 23, 24 auf, die Endanschlüsse einer von einer ersten Baugruppenteilmenge 25 der Schalterbaugruppen 3 gebildeten Teilreihenschaltung sind. Ein erster Modulanschluss 23 ist ein Mittelanschluss der Reihenschaltung der Schalterbaugruppen 3, der zweite Modulanschluss 24 ist ein Endanschluss der Reihenschaltung und mit der Kondensatorschaltung 19 verbunden. Die Schalterbaugruppen 3 einer zu der ersten Baugruppenteilmenge 25 komplementären zweiten Baugruppenteilmenge 26 der Schalterbaugruppen 3 bilden somit eine weitere Teilreihenschaltung von Schalterbaugruppen 3 zwischen dem ersten Modulanschluss 23 und der Kondensatorschaltung 19. Die Baugruppenteilmengen 25, 26 sind gleichmächtig, das heißt, sie weisen jeweils drei Schalterbaugruppen 3 auf. Der Begriff "komplementär" ist hier als Begriff der Mengenlehre zu verstehen: die erste Baugruppenteilmenge 25 der Schalterbaugruppen 3 und die (zu der ersten Baugruppenteilmenge komplementäre) zweite Baugruppenteilmenge 26 der Schalterbaugruppen 3 bilden also zusammen die Menge (Gesamtmenge, Baugruppenmenge) der Schalterbaugruppen 3 des Stromrichtermoduls 17.

Alle Schalterbaugruppen 3 oder wenigstens eine Teilmenge der Schalterbaugruppen 3 bilden eine Schaltungsanordnung 1, die analog zu einer der in den Figuren 1 bis 5 gezeigten Schaltungsanordnungen 1 ausgebildet ist. Beispielsweise bilden die Schalterbaugruppen 3 der beiden Baugruppenteilmengen 25, 26 jeweils eine anhand von Figur 4 beschriebene Schaltungsanordnung 1.

Das Stromrichtermodul 17 weist ferner ein Gehäuse 27 auf, in dem die Schalterbaugruppen 3, die Kondensatorschaltung 19 und ein Kühlmedium, beispielsweise ein Ester, angeordnet sind, um das Stromrichtermodul 17 zu kühlen.

In einem ersten Betriebsmodus (Normalbetrieb) des Stromrichtermoduls 17 werden die Halbleiterschalter 5 abwechselnd in einem erstem Schaltzustand und einem zweiten Schaltzustand betrieben, wobei in dem ersten Schaltzustand alle Halbleiterschalter 5 der ersten Baugruppenteilmenge 25 abgeschaltet und alle Halbleiterschalter 5 der zweiten Baugruppenteilmenge 26 eingeschaltet werden und in dem zweiten Schaltzustand alle Halbleiterschalter 5 der ersten Baugruppenteilmenge 25 eingeschaltet und alle Halbleiterschalter 5 der zweiten Baugruppenteilmenge 26 abgeschaltet werden.

Die Erfindung sieht ferner einen zweiten Betriebsmodus des Stromrichtermoduls 17 vor, in dem wenigstens ein Halbleiterschalter 5 wenigstens einer Baugruppenteilmenge 25, 26 abgeschaltet wird und wenigstens ein Halbleiterschalter 5 derselben Baugruppenteilmenge 25, 26 eingeschaltet wird, um durch das Stromrichtermodul 17 Energie, beispielsweise aus einem über die Modulanschlüsse 23, 24 mit dem Stromrichtermodul 17 verbundenen Stromnetz, aufzunehmen. Beispielsweise wird bei abgeschalteten Halbleiterschaltern 5 der zweiten Baugruppenteilmenge 26 ein Halbleiterschalter 5 der ersten Baugruppenteilmenge 25 eingeschaltet und die anderen beiden Halbleiterschalter 5 der ersten Baugruppenteilmenge 25 werden abgeschaltet. Dann kann ein elektrischer Strom zwischen den Modulanschlüssen 23, 24 über die Schalterbaugruppen 3 der ersten Baugruppenteilmenge 25 fließen, der teilweise über die Überspannungsableiter 7 dieser Schalterbaugruppe 3 fließt und diese Überspannungsableiter 7 erwärmt. Die Überspannungsableiter 7 geben die von ihnen aufgenommene Wärme teilweise an das sie umgebende Kühlmedium ab.

### Bezugszeichenliste

- 1: Schaltungsanordnung
- 3: Schalterbaugruppe
- 5: Halbleiterschalter
- 6: Freilaufdiode
- 7: Überspannungsableiter
- 9: Direktverbindung
- 11: Brückenverbindung
- 13: Stapelanschluss
- 15: Endbrückenverbindung
- 17: Stromrichtermodul
- 19: Kondensatorschaltung
- 21: Kondensator
- 23, 24: Modulanschluss
- 25, 26: Baugruppenteilmenge
- 27: Gehäuse

## Patentansprüche

1. Schaltungsanordnung (1), umfassend
- mehrere in Reihe geschaltete Schalterbaugruppen (3), die jeweils eine Parallelschaltung von drei Baugruppenkomponenten (5 bis 7) aufweisen, wobei
- eine erste Baugruppenkomponente ein Halbleiterschalter (5) ist, eine zweite Baugruppenkomponente eine Freilaufdiode (6) ist und die dritte Baugruppenkomponente ein Überspannungsableiter (7) ist,
- die Baugruppenkomponenten (5 bis 7) räumlich übereinander oder nebeneinander als ein Baugruppenkomponentenstapel angeordnet und die drei Baugruppenkomponenten (5 bis 7) jeder Schalterbaugruppe (3) in dem Baugruppenkomponentenstapel aufeinander folgend angeordnet sind,
- je zwei einander benachbarte Baugruppenkomponenten (5 bis 7) durch eine Direktverbindung (9) elektrisch direkt miteinander verbunden sind,
- jede Direktverbindung (9), die zwei Baugruppenkomponenten (5 bis 7) zweier verschiedener Schalterbaugruppen (3) verbindet, elektrisch mit jeder der beiden ihr zweitnächsten Direktverbindungen (9) durch eine Brückenverbindung (11) verbunden ist, und
- jedes Stapelende des Baugruppenkomponentenstapels einen elektrischen Stapelanschluss (13) aufweist, der durch eine Endbrückenverbindung (15) mit der dem Stapelende zweitnächsten Direktverbindung (9) zweier Baugruppenkomponenten (5 bis 7) elektrisch verbunden ist.

2. Schaltungsanordnung (1) nach Anspruch 1, wobei der Halbleiterschalter (5) und die Freilaufdiode (6) jeder Schalterbaugruppe (3) einander benachbart angeordnet sind.

3. Schaltungsanordnung (1) nach Anspruch 1 oder 2, wobei die Halbleiterschalter (5) Bipolartransistoren mit isoliertem Gate sind.

4. Schaltungsanordnung (1) nach Anspruch 3, wobei jede Direktverbindung (9), die zwei Bipolartransistoren mit isoliertem Gate verbindet, den Emitter eines Bipolartransistors mit isoliertem Gate und den Kollektor des anderen Bipolartransistors mit isoliertem Gate verbindet.

5. Schaltungsanordnung (1) nach Anspruch 3 oder 4, wobei jede Direktverbindung (9), die einen Bipolartransistor mit isoliertem Gate und eine Freilaufdiode (6) verbindet, entweder den Emitter des Bipolartransistors mit isoliertem Gate und die Anode der Freilaufdiode (6) oder den Kollektor des Bipolartransistors mit isoliertem Gate und die Kathode der Freilaufdiode (6) verbindet.

6. Schaltungsanordnung (1) nach einem der vorhergehenden Ansprüche, wobei jede Brückenverbindung (11) und/oder jede Endbrückenverbindung (15) einstückig mit jeder mit ihr verbundenen Direktverbindung (9) ausgeführt ist.

7. Stromrichtermodul (17), umfassend
- eine Reihenschaltung mehrerer Schalterbaugruppen (3), die jeweils eine Parallelschaltung von drei Baugruppenkomponenten (5 bis 7) aufweisen, wobei eine erste Baugruppenkomponente (5 bis 7) ein Halbleiterschalter (5) ist, eine zweite Baugruppenkomponente eine Freilaufdiode (6) ist und die dritte Baugruppenkomponente ein Überspannungsableiter (7) ist,
- eine mit den beiden Enden der Reihenschaltung verbundene Kondensatorschaltung (19) mit wenigstens einem Kondensator (21) und
- zwei Modulanschlüsse (23, 24), die Endanschlüsse einer von einer ersten Baugruppenteilmenge (25) der Schalterbaugruppen (3) gebildeten Teilreihenschaltung sind,
- wobei die Baugruppenkomponenten (5 bis 7) aller Schalterbaugruppen (3) oder wenigstens einer Teilmenge der Schalterbaugruppen (3) eine Schaltungsanordnung (1) nach einem der vorhergehenden Ansprüche bilden.

8. Stromrichtermodul (17) nach Anspruch 7 mit einer geraden Anzahl von Schalterbaugruppen (3), wobei die Mächtigkeit der ersten Baugruppenteilmenge (25) halb so groß wie die Anzahl der Schalterbaugruppen (3) ist.

9. Stromrichtermodul (17) nach Anspruch 7 oder 8 mit einem Gehäuse (27), in dem die Schalterbaugruppen (3), die Kondensatorschaltung (19) und ein Kühlmedium angeordnet sind.

10. Stromrichtermodul (17) nach Anspruch 9, wobei das Kühlmedium ein Ester ist.

11. Verfahren zum Betreiben eines gemäß einem der Ansprüche 7 bis 10 ausgebildeten Stromrichtermoduls (17), dessen erste Baugruppenteilmenge (25) wenigstens zwei Schalterbaugruppen (3) aufweist und das eine zu der ersten Baugruppenteilmenge (25) komplementäre zweite Baugruppenteilmenge (26) mit wenigstens zwei Schalterbaugruppen (3) aufweist, wobei zu einer Energieaufnahme durch das Stromrichtermodul (17) wenigstens ein Halbleiterschalter (5) wenigstens einer Baugruppenteilmenge (25, 26) abgeschaltet wird und wenigstens ein Halbleiterschalter (5) derselben Baugruppenteilmenge (25, 26) eingeschaltet wird.

## Claims

1. Circuit arrangement (1), comprising
- a plurality of switch assemblies (3) connected in series and each having a parallel circuit of three assembly components (5 to 7), wherein
- a first assembly component is a semiconductor switch (5), a second assembly component is a freewheeling diode (6) and the third assembly component is a surge arrester (7),
- the assembly components (5 to 7) are arranged spatially above one another or beside one another as an assembly component stack and the three assembly components (5 to 7) of each switch assembly (3) are arranged successively in the assembly component stack,
- each two mutually adjacent assembly components (5 to 7) are electrically directly connected to one another by a direct connection (9),
- each direct connection (9) that connects two assembly components (5 to 7) of two different switch assemblies (3) is electrically connected to each of the two direct connections (9) second closest to it by means of a bridge connection (11), and
- each stack end of the assembly component stack has an electrical stack terminal (13) that is electrically connected by means of an end bridge connection (15) to the direct connection (9) of two assembly components (5 to 7) that is second closest to the stack end.

2. Circuit arrangement (1) according to Claim 1, wherein the semiconductor switch (5) and the freewheeling diode (6) of each switch assembly (3) are arranged adjacent to one another.

3. Circuit arrangement (1) according to Claim 1 or 2, wherein the semiconductor switches (5) are insulated gate bipolar transistors.

4. Circuit arrangement (1) according to Claim 3, wherein each direct connection (9) that connects two insulated gate bipolar transistors connects the emitter of one insulated gate bipolar transistor and the collector of the other insulated gate bipolar transistor.

5. Circuit arrangement (1) according to Claim 3 or 4, wherein each direct connection (9) that connects an insulated gate bipolar transistor and a freewheeling diode (6) connects either the emitter of the insulated gate bipolar transistor and the anode of the freewheeling diode (6) or the collector of the insulated gate bipolar transistor and the cathode of the freewheeling diode (6).

6. Circuit arrangement (1) according to any of the preceding claims, wherein each bridge connection (11) and/or each end bridge connection (15) are/is embodied integrally with each direct connection (9) connected thereto.

7. Power converter module (17), comprising
- a series circuit of a plurality of switch assemblies (3), each having a parallel circuit of three assembly components (5 to 7), wherein a first assembly component (5 to 7) is a semiconductor switch (5), a second assembly component is a freewheeling diode (6) and the third assembly component is a surge arrester (7),
- a capacitor circuit (19) having at least one capacitor (21), said capacitor circuit being connected to the two ends of the series circuit, and
- two module terminals (23, 24), which are end terminals of a partial series circuit formed by a first assembly subset (25) of the switch assemblies (3),
- wherein the assembly components (5 to 7) of all the switch assemblies (3) or of at least one subset of the switch assemblies (3) form a circuit arrangement (1) according to any of the preceding claims.

8. Power converter module (17) according to Claim 7, having an even number of switch assemblies (3), wherein the cardinal number of the first assembly subset (25) is half the magnitude of the number of switch assemblies (3).

9. Power converter module (17) according to Claim 7 or 8, having a housing (27), in which the switch assemblies (3), the capacitor circuit (19) and a cooling medium are arranged.

10. Power converter module (17) according to Claim 9, wherein the cooling medium is an ester.

11. Method for operating a power converter module (17) embodied according to any of Claims 7 to 10, the first assembly subset (25) of which power converter module has at least two switch assemblies (3) and which power converter module has a second assembly subset (26) having at least two switch assemblies (3), said second assembly subset being complementary to the first assembly subset (25), wherein, for uptake of energy by the power converter module (17), at least one semiconductor switch (5) of at least one assembly subset (25, 26) is switched off and at least one semiconductor switch (5) of the same assembly subset (25, 26) is switched on.

## Revendications

1. Montage (1), comprenant
- plusieurs modules (3) d'interrupteur montés en série, qui ont chacun un circuit parallèle de trois composants (5 à 7) de module, dans lequel
- un premier composant de module est un interrupteur (5) à semi-conducteur, un deuxième composant de module est une diode (6) de roue libre et le troisième composant de module est un parafoudre (7),
- les composants (5 à 7) de module sont disposés les uns sur les autres ou les uns à côté des autres dans l'espace sous la forme d'un empilement de composants de module et les trois composants (5 à 7) de module de chaque module (3) d'interrupteur sont disposés successivement dans la pile de composants de module,
- respectivement deux composants (5 à 7) de module, voisins l'un de l'autre, sont reliés entre eux électriquement directement par une liaison (9) directe,
- chaque liaison (9) directe, qui relie deux composants (5 à 7) de module de deux modules (3) d'interrupteur différents, est reliée électriquement par une liaison (11) en pont à chacune des deux liaisons (9) directes qui lui sont les deuxièmes plus proches, et
- chaque extrémité de la pile de composants de module a une borne (13) électrique de pile, qui est, par une liaison (15) en pont d'extrémité, reliée électriquement à la liaison (9) directe la deuxième la plus proche de l'extrémité de la pile de deux composants (5 à 7) de module.

2. Montage (1) suivant la revendication 1, dans lequel l'interrupteur (5) à semi-conducteur et la diode (6) de roue libre de chaque module (3) d'interrupteur sont disposés en étant voisins l'un de l'autre.

3. Montage (1) suivant la revendication 1 ou 2, dans lequel les interrupteurs (5) à semi-conducteur sont des transistors bipolaires à grille isolée.

4. Montage (1) suivant la revendication 3, dans lequel chaque liaison (9) directe, qui relie deux transistors bipolaires à grille isolée, relie l'émetteur d'un transistor bipolaire à grille isolée et le collecteur de l'autre transistor bipolaire à grille isolée.

5. Montage (1) suivant la revendication 3 ou 4, dans lequel chaque liaison (9) directe, qui relie un transistor bipolaire à grille isolée et une diode (6) de roue libre, relie ou bien l'émetteur du transistor bipolaire à grille isolée et l'anode de la diode (6) de roue libre ou bien le collecteur du transistor bipolaire à grille isolée et la cathode de la diode (6) de roue libre.

6. Montage (1) suivant l'une des revendications précédentes, dans lequel chaque liaison (11) en pont et/ou chaque liaison (15) en pont d'extrémité est réalisée d'une seule pièce avec chaque liaison (9) directe qui lui est reliée.

7. Module (17) de convertisseur, comprenant
- un circuit série de plusieurs modules (3) d'interrupteur, qui ont chacun un circuit parallèle de trois composants (5 à 7) de module, dans lequel un premier composant (5 à 7) de module est un interrupteur (5) à semi-conducteur, un deuxième composant de module est une diode (6) de roue libre et le troisième composant de module est un parafoudre (7),
- un circuit (19) de condensateur relié aux deux extrémités du circuit série et ayant au moins un condensateur (21) et
- deux bornes (23, 24) de module, qui sont des bornes d'extrémité d'un circuit série partiel, formé d'un premier ensemble (25) partiel des modules (3) d'interrupteur,
- dans lequel les composants (5 à 7) de module de tous les modules (3) d'interrupteur ou au moins d'un ensemble partiel des modules (3) d'interrupteur forment un montage (1) suivant l'une des revendications précédentes.

8. Module (17) de convertisseur suivant la revendication 7, comprenant un nombre pair de modules (3) d'interrupteur, dans lequel le cardinal du premier ensemble (25) de modules est égal à la moitié du nombre des modules (3) d'interrupteur.

9. Module (17) de convertisseur suivant la revendication 7 ou 8 comprenant un boîtier (27), dans lequel sont disposés les modules (3) d'interrupteur, le circuit (19) de condensateur et un réfrigérant.

10. Module (17) de convertisseur suivant la revendication 9, dans lequel le réfrigérant est un ester.

11. Procédé pour faire fonctionner un module (17) de convertisseur qui est constitué suivant l'une des revendications 7 à 10, et dont un premier ensemble (25) partiel de modules comporte au moins deux modules (3) d'interrupteur et qui a un deuxième ensemble (26) partiel de modules, complémentaire du premier ensemble (25) partiel de modules, qui comporte au moins deux modules (3) d'interrupteur, dans lequel pour un prélèvement d'énergie par le module (17) de convertisseur, on ouvre au moins un interrupteur (5) à semi-conducteur d'au moins un ensemble (25, 26) partiel de modules et on ferme au moins un interrupteur (5) à semi-conducteur du même ensemble (25, 26) partiel de module.
